# EUROPEAN PATENT APPLICATION

(11) **EP 1 892 276 A1**
(43) Date of publication of application: **27.02.2008**
(21) Application number: 07016379.5
(22) Date of filing: 21.08.2007
(51) Int. Cl.: C09J 7/02

(54) **Pressure-sensitive adhesive sheet**

(30) Priority: 22.08.2006 JP 2006225540
(71) Applicant: NITTO DENKO CORPORATION, Osaka (JP)
(72) Inventor: Shintani, Toshio, Ibaraki-shi Osaka (JP); Asai, Fumiteru, Ibaraki-shi Osaka (JP); Yamamoto, Kazuhiko, Ibaraki-shi Osaka (JP)
(74) Representative: Grünecker, Kinkeldey, Stockmair & Schwanhäusser Anwaltssozietät

(57) **Abstract**

The present invention relates to a pressure-sensitive adhesive sheet for processing, which includes a substrate; a pressure-sensitive adhesive layer containing a radiation-polymerizable compound; and an interlayer containing an acrylic polymer having a glass transition temperature of 20°C or higher as a main component, the interlayer being disposed between the substrate and the pressure-sensitive adhesive layer. The pressure-sensitive adhesive sheet of the invention is excellent in pressure-sensitive adhesive properties, releasability, and expansibility.

## Description

### FIELD OF THE INVENTION

The present invention relates to a pressure-sensitive adhesive sheet for processing which is for use in processing a work such as a semiconductor wafer.

### BACKGROUND OF THE INVENTION

Semiconductor wafers made of silicon, germanium, gallium-arsenic, or the like are produced in a large-diameter form and thereafter subjected to the steps of dicing, cleaning, drying, expanding, pickup, and mounting in the state of having a pressure-sensitive adhesive sheet adherent to the back side thereof (the side opposite to the side on which circuit patterns have been formed).

Recently, the pressure-sensitive adhesive sheet for use in the step of semiconductor wafer dicing has been desired to be one which has sufficient adhesive force in the period from the dicing step to the expanding step and which, during pickup, has such a degree of adhesive force that the pressure-sensitive adhesive in the pressure-sensitive adhesive sheet does not remain adherent to the chips.

Such a pressure-sensitive adhesive sheet has been proposed in, e.g., patent documents 1 and 2 given later. This pressure-sensitive adhesive sheet is one which has a coating layer of a pressure-sensitive adhesive containing a low-molecular compound having at least two photopolymerizable carbon-carbon double bonds in the molecule thereof and in which the pressure-sensitive adhesive layer is capable of coming to have a three-dimensional network structure when the side a substrate made of poly(vinyl chloride) is irradiated with light.

However, the pressure-sensitive adhesive sheet disclosed in patent documents 1 and 2 has the following problems. During long-term storage, the radiation-polymerizable compound present in the pressure-sensitive adhesive layer migrates into the substrate made of poly(vinyl chloride). Therefore, when the pressure-sensitive adhesive sheet is used after long-term storage, there are cases where the curing reaction of the pressure-sensitive adhesive layer inducted by UV (ultraviolet) irradiation proceeds insufficiently due to the reduced content of the radiation-polymerizable compound. As a result, releasability remains low even after the UV irradiation. Namely, there has been a problem that the pressure-sensitive adhesive adheres to the chips in the course of picking up chips.

Furthermore, when a plasticizer present in the substrate migrates into the pressure-sensitive adhesive layer, the plasticizer often softens the pressure-sensitive adhesive layer. There has hence been a problem that when semiconductor chips are to be picked up after UV irradiation, they cannot be picked up without fail. There has also been a problem that before UV irradiation, this pressure-sensitive adhesive sheet has reduced adhesive force.

A pressure-sensitive adhesive sheet in which plasticizer migration from the substrate into the pressure-sensitive adhesive layer has been prevented is disclosed in, e.g., patent document 3 given later. This pressure-sensitive adhesive sheet has an interlayer disposed between a resin sheet as the substrate and the pressure-sensitive adhesive layer to thereby effectively inhibit plasticizer migration from the substrate to the pressure-sensitive adhesive layer. As the interlayer, a layer of a resin selected from polyethylene, polypropylene, poly(alkylene terephthalate), and modified alkyd resin is used . However, the pressure-sensitive adhesive sheet described in patent document 3 is not effective in sufficiently inhibiting even the migration of various additives such as an antiaging agent. As a result, in the expanding step which is conducted when the pressure-sensitive adhesive sheet is used in the processing of a semiconductor wafer, this pressure-sensitive adhesive sheet shows reduced expansibility and reduced recovery after expanding and the substrate is bent.

In order to overcome such problems, pressure-sensitive adhesive sheets intended to further prevent the migration of additives including an antiaging agent and thereby have improved expansibility, etc. are disclosed in, e.g., patent document 4 and patent document 5 given below. However, the pressure-sensitive adhesive sheets disclosed in these patent documents show an insufficient decrease in adhesive force through ultraviolet irradiation and their releasability is not sufficient.
Patent Document 1 : JP-A-60-196956
Patent Document 2 : JP-A-60-223139
Patent Document 3 : JP-A-1-56111
Patent Document 4 : Japanese Patent No. 3060417
Patent Document 5 : Japanese Patent No. 2703467

### SUMMARY OF THE INVENTION

The invention has been achieved in view of the problems described above. An object of the invention is to provide a pressure-sensitive adhesive sheet for processing which is excellent in pressure-sensitive adhesive properties, releasability, and expansibility.

The present inventors made intensive investigations on pressure-sensitive adhesive sheets for processing in order to overcome the problems of related-art techniques described above. As a result, they found that the object can be accomplished by disposing an interlayer containing an acrylic polymer having a given property as a main component between a substrate and a pressure-sensitive adhesive layer. The invention has been thus completed.

### BRIEF DESCRIPTION OF THE DRAWINGS

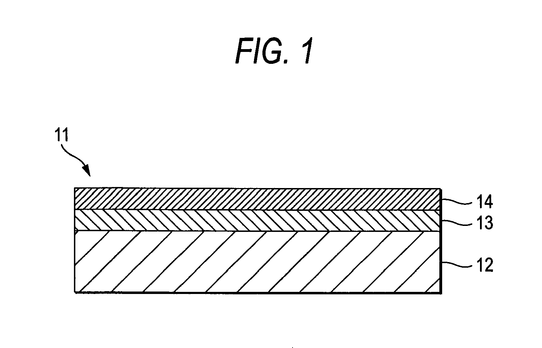

Fig. 1 is a diagrammatic sectional view illustrating the rough constitution of one embodiment of the pressure-sensitive adhesive sheet for processing of the invention.

### Description of the Reference Numerals

11 pressure-sensitive adhesive sheet for processing
12 substrate
13 interlayer
14 pressure-sensitive adhesive layer

### DETAILED DESCRIPTION OF THE INVENTION

In order to accomplish the above-mentioned object, the invention provides the following (1) to (12).
(1) A pressure-sensitive adhesive sheet for processing, which comprises:
   a substrate;
   a pressure-sensitive adhesive layer containing a radiation-polymerizable compound; and
   an interlayer containing an acrylic polymer having a glass transition temperature of 20°C or higher as a main component, said interlayer being disposed between the substrate and the pressure-sensitive adhesive layer.
(2) The pressure-sensitive adhesive sheet according to (1), wherein the substrate is a soft polyvinyl chloride film containing an additive.
(3) The pressure-sensitive adhesive sheet according to (1), wherein the pressure-sensitive adhesive layer contains a radiation polymerization initiator.
(4) The pressure-sensitive adhesive sheet according to (1), wherein the acrylic polymer comprises a methacrylate polymer or a methyl methacrylate polymer.
(5) The pressure-sensitive adhesive sheet according to (1), wherein the acrylic polymer contains a crosslinking agent incorporated therein.
(6) The pressure-sensitive adhesive sheet according to (5), wherein the crosslinking agent is contained in an amount of 0.1 to 50 parts by weight based on 100 parts by weight of a main polymer in the acrylic polymer.
(7) The pressure-sensitive adhesive sheet according to (1), wherein the acrylic polymer contains a plasticizer incorporated therein.
(8) The pressure-sensitive adhesive sheet according to (7), wherein the plasticizer is contained in an amount of 1 to 55 parts by weight based on 100 parts by weight of a main polymer in the acrylic polymer.
(9) The pressure-sensitive adhesive sheet according to (5), wherein the crosslinking agent is an epoxy crosslinking agent.
(10) The pressure-sensitive adhesive sheet according to (6), wherein the crosslinking agent is an epoxy crosslinking agent.
(11) The pressure-sensitive adhesive sheet according to (1), wherein the acrylic polymer has a glass transition temperature of 50°C to 130°C.
(12) The pressure-sensitive adhesive sheet according to (2), wherein the additive is at least one member selected from the group consisting of a plasticizer and antiaging agent.

When an interlayer containing an acrylic polymer having a glass transition temperature of 20°C or higher as a main component is disposed between the substrate and the pressure-sensitive adhesive layer as in the constitution described above, this interlayer functions as a barrier layer to prevent the radiation-polymerizable compound present in the pressure-sensitive adhesive layer from migrating into the substrate during room-temperature storage. Accordingly, when the pressure-sensitive adhesive layer is irradiated with a radiation, the pressure-sensitive adhesive layer can be sufficiently cured by the polymerization reaction of the radiation-polymerizable compound, whereby the releasability of the pressure-sensitive adhesive layer can be improved. As a result, the pressure-sensitive adhesive sheet can be stripped from the work while preventing it from leaving an adhesive residue on the work.

The substrate may be a soft polyvinyl chloride film containing at least an additive.

Even when the substrate contains additives such as a plasticizer and an antiaging agent, the interlayer can prevent these additives from migrating into the pressure-sensitive adhesive layer as in the constitution described above. Consequently, the softening of the pressure-sensitive adhesive layer attributable to plasticizer migration can be prevented to thereby prevent releasability from decreasing. Moreover, the interlayer can prevent the pressure-sensitive adhesive sheet from being reduced in stretchability and in recovery from stretching by antiaging agent migration, whereby the substrate can be prevented from bending.

The pressure-sensitive adhesive layer may contain a radiation polymerization initiator.

Even when the pressure-sensitive adhesive layer contains a radiation polymerization initiator as in the constitution described above, the interlayer can prevent the radiation polymerization initiator from migrating into the substrate. Consequently, the pressure-sensitive adhesive layer can be prevented from undergoing inhibition of radiation polymerization and from being insufficiently cured. As a result, the releasability of the pressure-sensitive adhesive layer can be kept satisfactory.

The acrylic polymer preferably contains a methacrylate polymer or a methyl methacrylate polymer.

By using a methacrylate polymer or methyl methacrylate polymer as the acrylate polymer, an interlayer having a high glass transition point can be formed.

It is preferred that the acrylic polymer contain a crosslinking agent incorporated therein.

By incorporating a crosslinking agent into the acrylic polymer, the interlayer can be made to have a three-dimensional network structure and the blocking function of the interlayer can be further improved.

The amount of the crosslinking agent to be incorporated is preferably 0.1 to 50 parts by weight based on 100 parts by weight of a main polymer in the acrylic polymer.

By regulating the amount of the crosslinking agent to be incorporated to 0.1 part by weight or larger based on 100 parts by weight of the main polymer, the blocking function of the interlayer can be kept on or above a certain level. On the other hand, by regulating the amount of the crosslinking agent to be incorporated to 50 parts by weight or smaller, the stretchability and recovery from stretching of the pressure-sensitive adhesive sheet can be kept in preferred ranges without causing the substrate to bend.

It is preferred that the acrylic polymer contain a plasticizer incorporated therein.

When the acrylic polymer contains a plasticizer as in the constitution described above, the plasticizer shows an affinity for a plasticizer which has migrated from the substrate. Accordingly, the plasticizer which has migrated from the substrate remain in the interlayer and plasticizer migration into the pressure-sensitive adhesive layer can be prevented. As a result, the pressure-sensitive adhesive layer can be prevented from being softened and reduced in releasability by plasticizer migration.

The amount of the plasticizer to be incorporated is preferably 1 to 55 parts by weight based on 100 parts by weight of the main polymer in the acrylic polymer.

By regulating the amount of the plasticizer to be incorporated to 1 part by weight or larger based on 100 parts by weight of the main polymer, the blocking function of the interlayer can be kept on or above a certain level. On the other hand, by regulating the amount of the plasticizer to be incorporated to 55 parts by weight or smaller, a work to which the pressure-sensitive adhesive sheet for processing of the invention has been applied can be processed while being prevented from suffering a trouble such as cracking or chipping.

The crosslinking agent is preferably an epoxy crosslinking agent.

When an epoxy crosslinking agent is employed, a curing reaction in the interlayer can be made to take place in a short time in comparison with the case where other crosslinking agents are employed. As a result, a pressure-sensitive adhesive sheet for processing, which is advantageous from the standpoint of production process, e.g., production efficiency improvement, can be provided.

The invention produces the following effects according to the means described above.

According to the pressure-sensitive adhesive sheet for processing of the invention, since an interlayer containing an acrylic polymer having a glass transition temperature of 20°C or higher as a main component is disposed between the substrate and the pressure-sensitive adhesive layer, the radiation-polymerizable compound and radiation polymerization initiator present in the pressure-sensitive adhesive layer can be prevented from migrating into the substrate. Consequently, the pressure-sensitive adhesive layer can retain its curing function and the decrease in releasability thereof can be minimized. As a result, a pressure-sensitive adhesive sheet for processing which is less apt to leave an adhesive residue and has excellent releasability can be provided.

Furthermore, since the interlayer prevents the plasticizer and antiaging agent present in the substrate from migrating into the pressure-sensitive adhesive layer, a pressure-sensitive adhesive sheet for processing, in which the pressure-sensitive adhesive layer is prevented from softening and which therefore can be prevented from decreasing in pressure-sensitive adhesive properties and expansibility and undergoing substrate bending, can be provided.

Embodiments of the invention will be explained below by reference to the drawing. It should be noted that parts unnecessary for the explanation have been omitted, and some parts are shown in an enlarged or reduced state in order to make the explanation easy.

Fig. 1 is a diagrammatic sectional view illustrating the rough constitution of one embodiment of the pressure-sensitive adhesive sheet for processing (hereinafter referred to simply as "pressure-sensitive adhesive sheet") of the invention. As shown in the figure, the pressure-sensitive adhesive sheet 11 as an embodiment has a structure including a substrate 12, interlayer 13, and pressure-sensitive adhesive layer 14 laminated in this order.

The substrate 12 serves as a supporting base for the interlayer 13 and the pressure-sensitive adhesive layer 14, and is constituted of a soft polyvinyl chloride film. The substrate 12 may have a single layer or may be a laminate composed of two or more layers. In the case where the substrate 12 is a laminate composed of two or more layers, this laminate may be one in which at least one layer is a soft polyvinyl chloride film. In this case, layer(s) other than the soft polyvinyl chloride film may be an undercoat layer as an uppermost layer of the substrate 12 so as to improve adhesion of the interlayer 13 to the substrate 12. Examples of such an undercoat layer include acrylic polymers obtained by copolymerization so as to incorporate, for example, acrylonitrile. The substrate 12 has the property of at least partly transmitting a radiation, such as X-rays, ultraviolet, or electron beams, so as to cure the pressure-sensitive adhesive layer 14 with the radiation. The substrate 12 preferably has flexibility so as to withstand expanding after dicing.

The material constituting the substrate 12 is not particularly limited. Examples thereof include poly(vinyl chloride), vinyl chloride copolymers such as urethane-vinyl chloride copolymers, ethylene-vinyl chloride copolymers, vinyl acetate-vinyl chloride copolymers, and ethylene-vinyl acetate copolymers, mixtures of two or more of them, and mixtures of any of them with one or more of other resins and elastomers. Those copolymers include graft copolymers and the mixtures include so-called alloys.

Besides the constituent material described above, a blend of two or more polymers may be used for the substrate 12 according to the necessity. Examples of such polymers include polyolefins such as low-density polyethylene, linear polyethylene, medium-density polyethylene, high-density polyethylene, ultralow-density polyethylene, propylene random copolymers, propylene block copolymers, propylene homopolymer, polybutene, and polymethylpentene, ionomer resins, ethylene/(meth)acrylic acid copolymers, ethylene/(meth)acrylic ester (random or alternating) copolymers, ethylene/butene copolymers, ethylene/hexene copolymers, polyurethanes, polyesters such as poly(ethylene terephthalate), polyimides, polyetheretherketones, poly(vinylidene chloride), fluororesins, cellulosic resins, and polymers obtained by crosslinking these polymers.

The substrate 12 may contain a plasticizer such as a phthalic ester including dibutyl phthalate, dioctyl phthalate, dinonyl phthalate, or diisodecyl phthalate, another polyester plasticizer, epoxy plasticizer, or trimellitic plasticizer. The epoxy plasticizer may be an epoxidized soybean oil which combines a secondary plasticizer with a stabilizer.

The substrate 12 may further contain a softener such as mineral oil, a filler such as calcium carbonate, silica, talc, mica, or clay, and various known additives such as an antioxidant, light stabilizer, antistatic agent, lubricant, dispersant, neutralizer, α-crystal nucleator, β-crystal nucleator, processing aid, and antiaging agent according to the necessity.

The substrate 12 may be an unstretched one, or may be one which has been stretched uniaxially or biaxially according to the necessity. The surface of the substrate 12 may optionally be subjected to a common physical or chemical treatment such as matting treatment, corona discharge treatment, primer treatment, or crosslinking treatment (chemical crosslinking (silane)). The thickness of the substrate 12 (total thickness when the substrate 12 is a laminate composed of two or more layers) is not particularly limited. The thickness thereof is preferably about 50 to 250 µm, more preferably about 70 to 230 µm.

The substrate 12 can be formed by a conventional film formation process. For example, use may be made of the wet casting method, inflation extrusion method, T-die extrusion method, or the like.

The interlayer 13 functions as a migration-preventive layer which blocks the migration of various additives contained in the substrate 12, such as a plasticizer and an antiaging agent, into the pressure-sensitive adhesive layer 14. By preventing the plasticizer and other additives from migrating, the pressure-sensitive adhesive layer 14 can be prevented from softening and decreasing in adhesive force. Furthermore, after irradiation with a radiation, the pressure-sensitive adhesive layer 14 can be prevented from decreasing in releasability due to softening. The interlayer 13 further functions to block the migration of the radiation polymerization initiator and radiation-polymerizable compound contained in the pressure-sensitive adhesive layer 14 into the substrate 12. Thus, when the pressure-sensitive adhesive layer 14 is irradiated with a radiation, the radiation-polymerizable compound can be prevented from insufficiently undergoing a curing reaction, whereby releasability can be prevented from decreasing.

The interlayer 13 contains, as a main component, an acrylic polymer having a glass transition temperature of 20°C or higher, and more preferably 50 to 130°C. Examples of the acrylic polymer include a methacrylate polymer and a methyl methacrylate polymer. The reason why the glass transition temperature of the polymer should be 20°C or higher is that use of the acrylic polymer having such a glass transition temperature has an advantage that this polymer can prevent migration in room-temperature tape storage and stable quality can be obtained for a long period. On the other hand, in the case where the glass transition temperature thereof is lower than 20°C, there is a problem that at room temperature, the interlayer shows a reduced function, resulting in accelerated migration.

The weight-average molecular weight of the material constituting the interlayer 13 is not particularly limited. However, it is preferably in the range of 1,000 to 2,000,000, and more preferably in the range of 3,000 to 1,500,000. By regulating the material so as to have a weight-average molecular weight within that range, the interlayer 13 can be made to have a sufficient blocking function.

The thickness of the interlayer 13 is not particularly limited. However, it is preferably in the range of 0.5 to 15 µm. By regulating the thickness thereof so as to be within that range, the interlayer formed can have a sufficient migration-preventive function.

The interlayer 13 may be constituted of a graft copolymer obtained from the acrylic polymer by grafting onto hydroxyl, carboxyl, amino, or other groups possessed by the acrylic polymer in order that the polymer be crosslinked.

It is preferred that the acrylic polymer contain a crosslinking agent incorporated therein. By incorporating a crosslinking agent into the acrylic polymer, the interlayer 13 can be made to have a three-dimensional network structure and the blocking function of the interlayer 13 can be further improved. The crosslinking agent is not particularly limited. Examples thereof include an epoxy crosslinking agent, an isocyanate crosslinking agent, and a melamine crosslinking agent. Among these crosslinking agents, it is preferable to use an epoxy crosslinking agent in the invention. This is because use of an epoxy crosslinking agent enables a curing reaction in the interlayer 13 to take place in a short time and, as a result, a pressure-sensitive adhesive sheet for processing, which is advantageous from the standpoint of production process, e.g., production efficiency improvement, can be provided.

The amount of the crosslinking agent to be incorporated is preferably 0.1 to 50 parts by weight, and more preferably 0.5 to 30 parts by weight, based on 100 parts by weight of the main polymer in the acrylic polymer. By regulating the amount of the crosslinking agent to be incorporated to 0.1 part by weight or larger based on 100 parts by weight of the main polymer, the blocking function of the interlayer 13 can be kept on or above a certain level. Namely, in the case where the amount thereof is smaller than 0.1 part by weight, there is a possibility that the blocking function might decrease. On the other hand, by regulating the amount of the crosslinking agent to be incorporated to 50 parts by weight or smaller, the stretchability and recovery from stretching of the pressure-sensitive adhesive sheet can be kept in preferred ranges without causing the substrate to bend. Namely, in the case where the amount thereof is larger than 50 parts by weight, there is a possibility that the stretchability and recovering from stretching of the pressure-sensitive adhesive sheet decrease to bend the substrate.

It is preferred that the acrylic polymer contain a plasticizer incorporated therein. When the acrylic polymer contains a plasticizer, the plasticizer shows, for example, an affinity for the plasticizer and other ingredients contained in the substrate 12 and thereby inhibits the plasticizer and other ingredients contained in the substrate 12 from migrating into the pressure-sensitive adhesive layer. As a result, the pressure-sensitive adhesive layer can be prevented from being softened and reduced in releasability by plasticizer migration. The plasticizer is not particularly limited, and specific examples thereof include phthalic esters such as dibutyl phthalate, dioctyl phthalate, dinonyl phthalate, and diisodecyl phthalate, other polyester plasticizers, epoxy plasticizers, and trimellitic plasticizers.

The amount of the plasticizer to be incorporated is preferably 1 to 55 parts by weight, and more preferably 3 to 45 parts by weight, based on 100 parts by weight of the main polymer in the acrylic polymer. By regulating the amount of the plasticizer to be incorporated to 1 part by weight or larger based on 100 parts by weight of the main polymer, the blocking function of the interlayer 13 can be kept on or above a certain level. Namely, in the case where the amount thereof is smaller than 1 part by weight, there is a possibility that it might be difficult to improve the blocking function. On the other hand, by regulating the amount of the plasticizer to be incorporated to 55 parts by weight or smaller, a work to which the pressure-sensitive adhesive sheet for processing of the invention has been applied can be processed while being prevented from suffering a trouble such as cracking or chipping.

The pressure-sensitive adhesive constituting the pressure-sensitive adhesive layer 14 is not particularly limited, and a conventional pressure-sensitive adhesive can be used. However, an acrylic pressure-sensitive adhesive is preferred in this embodiment. Specifically, it is preferred to use an acrylic polymer selected from homopolymers and copolymers containing acrylic ester units as the main constituent monomer units, a copolymer with one or more functional monomers, or a mixture of two or more of these polymers.

Preferred examples of the acrylic ester include butyl methacrylate, 2-ethylhexyl methacrylate, glycidyl methacrylate, and 2-hydroxyethyl methacrylate. Also preferred are compounds which are the same as those methacrylates except that the methacrylic acid moiety has been replaced by, e.g., an acrylic acid moiety. As the pressure-sensitive adhesive polymer constituting the pressure-sensitive adhesive, use may be made of various polymers such as rubber, acrylic, silicone, and vinyl ester polymers. An acrylic polymer is especially preferred of these pressure-sensitive adhesive polymers from the standpoint of, e.g., removability in the cleaning of electronic parts which should be prevented from being fouled, such as semiconductor wafers and glasses, with ultrapure water or an organic solvent such as an alcohol. Unlike the acrylic polymer used in the interlayer 13, this acrylic polymer should have pressure-sensitive adhesive properties at ordinary temperature (about 23°C) and hence has a glass transition temperature of preferably 0°C or lower, and more preferably - 10°C to -20°C.

Examples of the acrylic polymer include acrylic polymers obtained from one or more monomer ingredients selected from alkyl esters of (meth)acrylic acid (e.g., linear or branched alkyl esters in which the alkyl group has 1 to 30, especially 4 to 18 carbon atoms, such as the methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester) and from cycloalkyl esters of (meth)acrylic acid (e.g., the cyclopentyl ester and cyclohexyl ester).

Also usable are copolymers of one or more of the alkyl esters of (meth)acrylic acid enumerated above and one or more of other copolymerizable monomers such as hydroxyalkyl esters of (meth)acrylic acid (e.g., the hydroxyethyl ester, hydroxybutyl ester, and hydroxyhexyl ester), glycidyl (meth)acrylate, (meth)acrylic acid, itaconic acid, maleic anhydride, (meth)acrylamide, N-hydroxymethyl(meth)acrylamide, alkylaminoalkyl esters of (meth)acrylic acid (e.g., the dimethylaminoethyl ester and t-butylaminoethyl ester), vinyl acetate, styrene, and acrylonitrile. The term "alkyl ester of (meth)acrylic acid" means an alkyl ester of acrylic acid and/or an alkyl ester of methacrylic acid. The term "(meth)" in the invention has the same meaning in every case.

In the acrylic polymer, a polyfunctional monomer or the like may be contained as a monomer components for crosslinking according to the necessity for the purpose of crosslinking. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylates, polyester (meth)acrylates, and urethane (meth)acrylate. These polyfunctional monomers also may be used alone or in combination of two or more thereof. The amount of the polyfunctional monomer to be used is preferably 30% by weight or less based on all monomer ingredients from the standpoints of pressure-sensitive adhesive properties, etc.

The acrylic polymer is obtained by polymerizing a single monomer or a mixture of two or more monomers. The polymerization may be conducted by any of solution polymerization, emulsion polymerization, bulk polymerization, suspension polymerization, and the like. The molecular weight of the acrylic polymer may be generally 200,000 or higher, preferably 300,000 to 2,000,000, and more preferably 500,000 to 1,500,000, in terms of weight-average molecular weight.

An external crosslinking agent may be suitably used for the pressure-sensitive adhesive layer in order to heighten the weight-average molecular weight of the acrylic polymer as the base polymer. Specific examples of methods of external crosslinking include a method in which a so-called crosslinking agent such as a polyisocyanate compound, epoxy compound, aziridine compound, or melamine crosslinking agent is added and reacted. In the case of using an external crosslinking agent, the amount of the crosslinking agent to be used is suitably determined according to a balance with the base polymer to be crosslinked and to the intended use of the pressure-sensitive adhesive. In general, it is preferred to incorporate an external crosslinking agent in an amount of about 5 parts by weight or less, especially 0.1 to 5 parts by weight, based on 100 parts by weight of the base polymer. Besides the ingredients described above, conventional various additives such as a tackifier and an antiaging agent may be added to the pressure-sensitive adhesive.

The pressure-sensitive adhesive layer 14 in this embodiment contains a radiation-polymerizable compound. Upon irradiation with a radiation, this radiation-polymerizable compound contained in the pressure-sensitive adhesive layer 14 is polymerized, whereby the adhesive force of the pressure-sensitive adhesive layer 14 can be reduced. Examples of the radiation-polymerizable compound include a radiation-polymerizable compound ingredient having a weight-average molecular weight of about 500 to 40,000, and more preferably about 750 to 30,000.

Extensively used as the radiation-polymerizable compound are low-molecular compounds which are capable of forming a three-dimensional network structure upon irradiation with a radiation such as ultraviolet or electron beams and have at least two photopolymerizable carbon-carbon double bonds in the molecule thereof, as disclosed in, e.g., JP-A-60-196956 and JP-A-60-223139. Examples thereof include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate, and commercial oligoester acrylates.

As the radiation-polymerizable compound, a urethane acrylate oligomer may be used besides the compounds enumerated above. Especially, in the case that a urethane acrylate oligomer having a weight-average molecular weight of 500 to 40,000, preferably 750 to 30,000, is used, the pressure-sensitive adhesive can be prevented from adhering to the chip surface in semiconductor chip pickup even when the semiconductor wafer surface is rough.

The amount of the radiation-polymerizable compound to be incorporated is, for example, preferably about 10 parts by weight or larger, and more preferably 20 to 140 parts by weight, based on 100 parts by weight of the base polymer constituting the pressure-sensitive adhesive, e.g., an acrylic polymer. The content of a radiation-polymerizable compound having a weight-average molecular weight of 750 or higher is preferably 40% by weight or higher, and more preferably 60 to 100% by weight.

The pressure-sensitive adhesive layer 14 in this embodiment may contain a radiation polymerization initiator so as to cure by the action of a radiation, e.g., ultraviolet. As the radiation polymerization initiator, use may be made of one which has a molar extinction coefficient at 365 nm, which is a characteristic wavelength of high-pressure mercury lamps in general use in semiconductor device production steps, of 1,000 mol⁻¹·cm⁻¹ or higher, preferably 1,500 mol¹·cm⁻¹ or higher (usually 30,000 mol⁻¹·cm⁻¹ or lower), and has a maximum absorption wavelength on the longer-wavelength side of 420 nm or longer, preferably 430 nm or longer (usually 460 nm or shorter). Specific examples thereof include 2-benzyl-2-dimethylamino-1-(4-morpholinophenyl)butanone-1 and bis(2,4,6-trimethylbenzoyl)phenylphosphine oxide. Other examples of the radiation polymerization initiator include α-ketol compounds such as 4-(2-hydroxyethoxy)phenyl 2-hydroxy-2-propyl ketone, α-hydroxy-α,α'-dimethylacetophenone, 2-methyl-2-hydroxypropiophenone, and 1-hydroxycyclohexyl phenyl ketone; acetophenone compounds such as methoxyacetophenone, 2,2-dimethoxy-2-phenylacetophenone, 2,2-diethoxyacetophenone, and 2-methyl-1-[4-(methylthio)phenyl]-2-morpholinopropane-1; benzoin ether compounds such as benzoin ethyl ether, benzoin isopropyl ether, and anisoin methyl ether; ketal compounds such as benzyl dimethyl ketal; aromatic sulfonyl chloride compounds such as 2-naphthalenesulfonyl chloride; optically active oxime compounds such as 1-phenyl-1,1-propanedione-2-(o-ethoxycarbonyl) oxime; benzophenone compounds such as benzophenone, benzoylbenzoic acid, and 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphinoxides; and acylphosphonates.

The amount of the radiation polymerization initiator to be incorporated is, for example, about 20 to 140 parts by weight based on 100 parts by weight of the base polymer constituting the pressure-sensitive adhesive, e.g., an acrylic polymer.

The pressure-sensitive adhesive sheet 11 according to this embodiment can be advantageously used for the processing of, e.g., a semiconductor (Si, Ge, Ga-As, etc.) wafer. For example, the pressure-sensitive adhesive sheet 11 is applied to a side of a semiconductor wafer on which circuit patterns have been formed, and this semiconductor wafer is diced to produce semiconductor chips. Thereafter, the pressure-sensitive adhesive sheet 11 is irradiated with a radiation and the semiconductor chips are picked up. Since the pressure-sensitive adhesive sheet 11 according to this embodiment has the function of sufficiently curing upon irradiation with a radiation, it can be easily peeled off without leaving an adhesive residue on the semiconductor chips. Accordingly, this pressure-sensitive adhesive sheet 11 has excellent suitability for pickup. Furthermore, the pressure-sensitive adhesive layer 14 retains the function of sufficiently curing upon irradiation with a radiation. Consequently, the pressure-sensitive adhesive sheet 11 also has excellent long-term storability.

### Other Matters

The explanation given above was made on the most preferred embodiment of the invention. However, the invention should not be construed as being limited to that embodiment, and various modifications can be made in substantially the same range as the technical ideas described in the claims.

Namely, the pressure-sensitive adhesive sheet for processing of the invention may have a release layer superposed thereon for the protection of the pressure-sensitive adhesive layer. Examples of the release layer include conventional ones constituted of a plastic film (e.g., poly(ethylene terephthalate) or polypropylene), paper, nonpolar material (e.g., polyethylene or polypropylene), or the like. The release layer may have undergone a releasant treatment such as a silicone treatment, long-chain-alkyl treatment, or fluorochemical treatment. The release layer enables the pressure-sensitive adhesive sheet to be wound into a roll. Although the thickness of the release layer is not particularly limited, it is generally about 10 to 200 µm, preferably about 25 to 100 µm.

Applications of the pressure-sensitive adhesive sheet for processing of the invention are not limited to the processing of a semiconductor wafer. It is suitable also for use as a pressure-sensitive adhesive sheet for the dicing of a semiconductor package, glass, etc.

The pressure-sensitive adhesive sheet for processing of the invention can be in any of various forms including tape and label forms.

### Examples

Preferred Examples of the invention will be illustratively explained below in detail. However, the materials, amounts, etc. shown in the following Examples should not be construed as limiting the scope of the invention thereto unless there particularly is a restrictive statement. The Examples are given for mere explanation. Hereinafter, "parts by weight" will be referred to simply as "parts".

### Example 1

Ninety-eight parts of methyl methacrylate was copolymerized with 2 parts of acrylic acid in an ordinary manner to obtain a solution containing an acrylic polymer having a weight-average molecular weight of 80,000 (glass transition temperature, 95°C).

The solution containing the acrylic polymer was subsequently applied to a separator and dried to form an interlayer (thickness, 5 µm). This interlayer was transferred onto a flexible polyvinyl chloride film (substrate, having a thickness of 100 µm). Incidentally, the flexible polyvinyl chloride film contained DOP (dioctyl phthalate) as a plasticizer.

Subsequently, 50 parts of methyl acrylate, 20 parts of 2-ethylhexyl acrylate, and 5 parts of acrylic acid were copolymerized in an ordinary manner to obtain a solution containing an acrylic polymer having a weight-average molecular weight of 1,000,000. To 100 parts of this solution were added 3 parts of 2,2-dimethoxy-1,2-phenylethan-1-one (trade name "Irgacure 651 ", manufactured by Ciba Specialty Chemicals Co.,; molar extinction coefficient at wavelength of 365 nm, 1,500 mol⁻¹·cm⁻¹; maximum absorption wavelength on longer-wavelength side, 400 nm) as a photopolymerization initiator and 2 parts of a melamine crosslinking agent as a crosslinking agent. Furthermore, 60 parts of UV Oligomer 1700B (trade name; manufactured by The Nippon Synthetic Chemical Industry Co., Ltd.) was added as a radiation-polymerizable compound to the solution. Thus, a solution of an ultraviolet-curable pressure-sensitive adhesive composition was obtained.

The solution of an ultraviolet-curable pressure-sensitive adhesive composition was applied to a separator and dried to form a pressure-sensitive adhesive layer (thickness, 5 µm). This pressure-sensitive adhesive layer was transferred onto the interlayer. Thus, a pressure-sensitive adhesive sheet A according to Example 1 was produced.

### Example 2

This Example differs from Example 1 in that an acrylic polymer containing poly(methyl methacrylate) was used as an interlayer-constituting material in place of the acrylic polymer used in Example 1. The acrylic polymer containing poly(methyl methacrylate) had a weight-average molecular weight of 50,000 and a glass transition temperature of 105°C. The pressure-sensitive adhesive sheet obtained in this Example is referred to as pressure-sensitive adhesive sheet B.

### Example 3

In this Example, an interlayer-constituting material prepared in the following manner was used. An acrylic polymer containing NK-380 (trade name; manufactured by Nippon Shokubai Co., Ltd.), which had amino groups introduced by graft copolymerization, was prepared in place of the acrylic polymer used in Example 1. To 100 parts of this acrylic polymer were added 20 parts of an epoxy crosslinking agent (trade name, Epikote 828; manufactured by Japan Epoxy Resins Co., Ltd.) and 40 parts of dioctyl phthalate as a plasticizer. Thus, a material for constituting an interlayer was produced. A pressure-sensitive adhesive sheet C according to this Example was produced in the same manner as in Example 1, except that this material was used. The acrylic polymer comprising NK-380 had a weight-average molecular weight of 70,000 and a glass transition temperature of 90°C.

### Comparative Example 1

Fifty parts of methyl acrylate, 20 parts of 2-ethylhexyl acrylate, and 5 parts of acrylic acid were copolymerized in an ordinary manner to obtain a solution containing an acrylic polymer having a weight-average molecular weight of 1,000,000. To 100 parts of this solution were added 3 parts of 2,2-dimethoxy-1,2-phenylethan-1-one (trade name "Irgacure 651 ", manufactured by Ciba Specialty Chemicals Co.,; molar extinction coefficient at wavelength of 365 nm, 1,500 mol⁻¹·cm⁻¹; maximum absorption wavelength on longer-wavelength side, 400 nm) as a photopolymerization initiator and 2 parts of a melamine crosslinking agent as a crosslinking agent. Furthermore, 60 parts of UV Oligomer 1700B (trade name; manufactured by The Nippon Synthetic Chemical Industry Co., Ltd.) was added as a radiation-polymerizable compound to the solution. Thus, a solution of an ultraviolet-curable pressure-sensitive adhesive composition was obtained.

The solution of an ultraviolet-curable pressure-sensitive adhesive composition was applied to a separator and dried to form a pressure-sensitive adhesive layer (thickness, 5 µm). This pressure-sensitive adhesive layer was transferred onto the flexible polyvinyl chloride film (substrate, having a thickness of 100 µm). Thus, a pressure-sensitive adhesive sheet D according to Comparative Example 1 was produced.

### Comparative Example 2

This Comparative Example differs from Example 1 in that an acrylic polymer having a weight-average molecular weight of 300,000 obtained by copolymerizing 50 parts of 2-ethylhexyl acrylate, 45 parts of butyl acrylate, and 5 parts of acrylic acid in an ordinary manner was used as an interlayer-constituting material in place of the acrylic polymer used in Example 1. That acrylic polymer had a glass transition temperature of -27.5°C. The pressure-sensitive adhesive sheet obtained in this Comparative Example is referred to as pressure-sensitive adhesive sheet E.

### Measurement of Glass Transition Temperature

Glass transition temperature was determined by DSC (differential scanning calorimetry).

### Weight-Average Molecular Weight

Gel permeation chromatograph "GPC-150C", manufactured by Waters Inc., was used to make an examination at 135°C using o-dichlorobenzene as a solvent and "Shodex-80M", manufactured by Showa Denko K.K., as a column. Tada processing was conducted with a data collection system manufactured by TRC. The molecular weight was calculated for standard polystyrene.

### Evaluation

The pressure-sensitive adhesive sheets obtained in Examples 1 to 3 and Comparative Examples 1 and 2 were stored for 6 months and then examined for peel adhesive force before and after ultraviolet irradiation.

### <Peel Adhesive Force Test>

Each pressure-sensitive adhesive sheet was cut along the machine direction to obtain sample pieces having a width of 20 mm and a length of 12 cm. These samples were applied to a silicon mirror wafer and allowed to stand for about 30 minutes. One sample was then examined for peel adhesive force before ultraviolet irradiation. Furthermore, another sample was irradiated with ultraviolet under the following irradiation conditions and then examined for peel adhesive force. The examination conditions included the following: examination apparatus, Tensilon; pulling rate, 300 mm/min; peel angle, 90°.

### <Irradiation Conditions>

A high-pressure mercury lamp was used as a light source under the conditions of an irradiation intensity of 50 mW/cm² (measured with "Ultraviolet Illuminometer UT101" manufactured by Ushio Inc.) and an irradiation period of 20 seconds.

### <Dicing Conditions>

Silicon mirror wafers respectively having the pressure-sensitive adhesive sheets A to E applied thereto each were cut into 8 mm × 8 mm chips by down cutting with a dicer (DFD-651, manufactured by Disco Corp.) and a blade (27HECC, manufactured by Disco Corp.) under the conditions of a dicing speed of 80 m/min, dicing blade rotation speed of 40,000 rpm, and cutting depth in the pressure-sensitive adhesive sheet (depth from the surface of the pressure-sensitive adhesive sheet) of 30 µm.

### <Stability for Pickup>

Two hundred chips having a size of 8 mm × 8 mm obtained by the dicing were picked up with a die bonder (NEC Machinery CPS-100). The chips thus picked up were examined for adhesion of the pressure-sensitive adhesive to the back side thereof, i.e., for an adhesive residue left on the back side thereof This examination for an adhesive residue was made visually or with a microscope (50 to 500 magnifications). The pickup was conducted after the pressure-sensitive adhesive sheet had been irradiated with ultraviolet under the conditions shown above. Pickup conditions used are as follows.

### Number of pins: 4

Distance between pins: 3.5 mm × 3.5 mm
Curvature radius of pin tip: 0.250 mm
Pin pushing-up amount: 0.50 mm
Pin pushing-up speed: 50 mm/sec

The pressure-sensitive adhesive sheets which result in good stability for Pickup are indicated by A. On the other hand, the pressure-sensitive adhesive sheets which result in poor stability for Pickup are indicated by B.

### <Expansibility>

The pressure-sensitive adhesive sheets A to E were evaluated also for expansibility. Namely, dicing ring 2-6-1 (manufactured by Disco Corp; inner diameter, 19.5 cm) and die bonder CPS-100 (manufactured by NEC Machinery) were used under the conditions of a pulling-down amount of 13 mm to evaluate the distance between chips. The pressure-sensitive adhesive sheets in which the distance was 10 mm or larger are indicated by A. On the other hand, the pressure-sensitive adhesive sheets in which the distance was smaller than 10 mm are indicated by B.

**Table 1**

| | Adhesive force before UV irradiation (N/20-mm width) | Adhesive force after UV irradiation (N/20-mm width) | Suitability for pickup | Adhesive residue | Expansibility | Substrate bending |
|---|---|---|---|---|---|---|
| Pressure-sensitive adhesive sheet A | 10.42 | 0.29 | A | absent | A | not occurred |
| Pressure-sensitive adhesive sheet B | 12.00 | 0.22 | A | absent | A | not occurred |
| Pressure-sensitive sheet adhesive sheet C | 8.80 | 0.10 | A | absent | A | not occurred |
| Pressure-sensitive sheet adhesive sheet D | 5,50 | 0.83 | B | present | B | occurred |
| Pressure-sensitive adhesive sheet E | 6.20 | 0.55 | B | slightly present | A | occurred |

As apparent from Table 1, the adhesive forces before UV irradiation of the pressure-sensitive adhesive sheets A to C obtained in Examples 1 to 3 were 10.42 N/20-mm width, 12.00 N/20-mm width, and 8.80 N/20-mm width, respectively. In contrast, the adhesive force before UV irradiation of the pressure-sensitive adhesive sheet D obtained in Comparative Example 1 was 5.50 N/20-mm width. Furthermore, the adhesive forces after UV irradiation of the pressure-sensitive adhesive sheets A to C obtained in Examples 1 to 3 were 0.29 N/20-mm width, 0.22 N/20-mm width, and 0.10 N/20-mm width, respectively. In contrast, the adhesive force after UV irradiation of the pressure-sensitive adhesive sheet D obtained in Comparative Example 1 was 0.83 N/20-mm width. It was thus ascertained that in each of the pressure-sensitive adhesive sheets A to C obtained in Examples 1 to 3, the pressure-sensitive adhesive layer still contained the radiation-polymerizable compound and radiation polymerization initiator in sufficient amounts at the time of UV irradiation and that these pressure-sensitive adhesive sheets retained given releasability.

Furthermore, the pressure-sensitive adhesive sheets were examined as to whether they left an adhesive residue on a silicon mirror wafer. As a result, the pressure-sensitive adhesive sheets A to C left no adhesive residue, whereas an adhesive residue was observed when the pressure-sensitive adhesive sheets D and E were used. These results indicate that when the pressure-sensitive adhesive sheets D and E obtained in the Comparative Examples are used, there is a possibility that the pickup of semiconductor chips might result in a pickup failure. In contrast, the pressure-sensitive adhesive sheets A to C obtained in Examples 1 to 3 are thought to show satisfactory suitability for pickup.

With respect to expansibility, use of the pressure-sensitive adhesive sheets A to C obtained in Examples 1 to 3 resulted in chip distances of 200, 120, and 210 µm, respectively. These pressure-sensitive adhesive sheets thus showed sufficient stretchability. It was further ascertained that the substrates had not bent. In contrast, the pressure-sensitive adhesive sheet D obtained in Comparative Example 1 broke before the pulling-down amount reached 10 mm.

While the present invention has been described in detail and with reference to specific embodiments thereof, it will be apparent to one skilled in the art that various changes and modifications can be made therein without departing from the scope thereof.

This application is based on Japanese patent application No. 2006-225540 filed August 22, 2006, the entire contents thereof being hereby incorporated by reference.

Further, all references cited herein are incorporated in their entireties.

## Claims

1. A pressure-sensitive adhesive sheet for processing, which comprises:
a substrate;
a pressure-sensitive adhesive layer containing a radiation-polymerizable compound; and
an interlayer containing an acrylic polymer having a glass transition temperature of 20°C or higher as a main component, said interlayer being disposed between the substrate and the pressure-sensitive adhesive layer.

2. The pressure-sensitive adhesive sheet according to claim 1, wherein the substrate is a soft polyvinyl chloride film containing an additive.

3. The pressure-sensitive adhesive sheet according to claim 1, wherein the pressure-sensitive adhesive layer contains a radiation polymerization initiator.

4. The pressure-sensitive adhesive sheet according to claim 1, wherein the acrylic polymer comprises a methacrylate polymer or a methyl methacrylate polymer.

5. The pressure-sensitive adhesive sheet according to claim 1, wherein the acrylic polymer contains a crosslinking agent incorporated therein.

6. The pressure-sensitive adhesive sheet according to claim 5, wherein the crosslinking agent is contained in an amount of 0.1 to 50 parts by weight based on 100 parts by weight of a main polymer in the acrylic polymer.

7. The pressure-sensitive adhesive sheet according to claim 1, wherein the acrylic polymer contains a plasticizer incorporated therein.

8. The pressure-sensitive adhesive sheet according to claim 7, wherein the plasticizer is contained in an amount of 1 to 55 parts by weight based on 100 parts by weight of a main polymer in the acrylic polymer.

9. The pressure-sensitive adhesive sheet according to claim 5, wherein the crosslinking agent is an epoxy crosslinking agent.

10. The pressure-sensitive adhesive sheet according to claim 6, wherein the crosslinking agent is an epoxy crosslinking agent.

11. The pressure-sensitive adhesive sheet according to claim 1, wherein the acrylic polymer has a glass transition temperature of 50°C to 130°C.

12. The pressure-sensitive adhesive sheet according to claim 2, wherein the additive is at least one member selected from the group consisting of a plasticizer and antiaging agent.
